# EUROPEAN PATENT APPLICATION

(11) **EP 4 421 246 A1**
(43) Date of publication of application: **28.08.2024**
(21) Application number: 22900856.0
(22) Date of filing: 08.08.2022
(51) Int. Cl.: E02F 9/16, H05K 7/20

(54) **ELECTRONIC DEVICE SUPPORT MECHANISM AND CONSTRUCTION MACHINE COMPRISING ELECTRONIC DEVICE SUPPORT MECHANISM**

(30) Priority: 03.12.2021 JP 2021197189
(71) Applicant: KOBELCO CONSTRUCTION MACHINERY CO., LTD., Hiroshima-shi, Hiroshima 731-5161 (JP)
(72) Inventor: TAKAMATSU Nobuhiro, Hiroshima-shi, Hiroshima 731-5161 (JP); FUJIWARA Yusuke, Hiroshima-shi, Hiroshima 731-5161 (JP); MATONO Masataka, Hiroshima-shi, Hiroshima 731-5135 (JP); SAWADA Yusuke, Hiroshima-shi, Hiroshima 731-5161 (JP)
(74) Representative: Schön, Christoph
(86) International application number: PCT/JP2022/030294
(87) International publication number: WO 2023/100421

(57) **Abstract**

The present invention provides an electronic device support mechanism that ensures heat dissipation capability for an electronic device mounted on a construction machine, and a construction machine including the electronic device support mechanism. The electronic device support mechanism of the present invention includes a housing 21 that is disposed with a space adjacent to a lower structural object on a back side of a seat in an operating cab 2 of a construction machine and in which an electronic device is housed, and one or more side wall parts 29 of the housing 21 and a lower wall part 22 of the housing 21 are each provided with one selected from among a vent 43 and a fan 42.

## Description

### Technical Field

The present invention relates to an electronic device support mechanism that supports an electronic device to a construction machine, and a construction machine comprising the electronic device support mechanism.

### Background Art

Recently, inventions related to a remote operation device that remotely operates a vehicle such as a construction machine as disclosed in Patent Literature 1 have been made. In such remote operation, an operator performs remote operation while viewing a video of surroundings of a construction machine, which is transmitted from the construction machine. The video of surroundings of the construction machine, operational status data of the construction machine, and data such as operation signals from the remote operation device are transmitted and received through wireless communication between the construction machine remotely operated and a remote operation device operated by the operator, and accordingly, the construction machine is remotely operated.

An electronic device for remote operation communication is mounted on a remotely operated construction machine. In a construction machine disclosed in Patent Literature 2, with consideration of actual maneuvering by a pilot on board the construction machine even after an electronic device is mounted, the electronic device is installed on the back side of an operation seat to avoid interference with maneuvering by the pilot.

### Citation List

### Patent Literature

Patent Literature 1: Japanese Patent Laid-Open No. 2021-150931
Patent Literature 2: Japanese Patent Laid-Open No. 2020-084651

### Summary of Invention

### Technical Problem

However, a space between a seat in an operating room and a wall part on the back side of the seat is an extremely limited space, and it has been difficult to mount an electronic device while ensuring heat dissipation capability of heat generated by the electronic device in operation.

The present invention has been made to solve the above-described problem and intended to provide an electronic device support mechanism that ensures heat dissipation capability for an electronic device mounted on a construction machine, and a construction machine comprising the electronic device support mechanism.

### Solution to Problem

An electronic device support mechanism of the present invention comprises a housing that is disposed with a space adjacent to a lower structural object on a back side of a seat comprised in an operating cab of a construction machine and in which an electronic device is housed, and one or more side wall parts of the housing and a lower wall part of the housing are each provided with one selected from among a vent and a fan.

### Brief Description of Drawings

FIG. 1 is a perspective view of an operating cab according to an embodiment.
FIG. 2 is a left side view of the operating cab in FIG. 1.
FIG. 3 is a top view of the operating cab in FIG. 1.
FIG. 4 is a front view of an electronic device housing module of the embodiment of the present invention.
FIG. 5 is a perspective view of a housing included in the electronic device housing module in FIG. 4.
FIG. 6 is a perspective view of a fixation element included in the electronic device housing module in FIG. 4.
FIG. 7 is a partially enlarged diagram of part A corresponding to an airflow adjustment member in FIG. 4.
FIG. 8 is a front view illustrating a state in which a front wall part of the housing in FIG. 4 is omitted.

### Description of Embodiment

An embodiment of an electronic device support mechanism and a construction machine comprising the electronic device support mechanism according to the present invention will be described below with reference to the accompanying drawings. The construction machine comprises a remote operation electronic device and can be remotely operated by an operator without a person on board the machine. The construction machine can perform mutual network communication with a remote operation support server and a remote operation device. Note that illustrations of the remote operation support server and the remote operation device operated by the operator as well as their configurations are omitted.

The remote operation support server is a device connecting the construction machine and the remote operation device and configured to perform arithmetic processing for remotely operating the construction machine. The remote operation support server comprises an arithmetic processing device and a storage device including a database. The arithmetic processing device reads necessary data and software from the storage device and executes arithmetic processing of the data in accordance with the software.

The remote operation device is a device with which the operator on board remotely operates the construction machine. The remote operation device comprises a remote operation device, a remote input interface, and a remote output interface. The remote operation device comprises an arithmetic processing device and a storage device and executes arithmetic processing related to operation input at the remote operation device and signal output including a video from the construction machine. The remote input interface comprises a remote operation mechanism operated by the operator. The remote output interface comprises a remote image output device for recognition by the operator, and a remote sound output device, and a remote wireless communication instrument configured to transmit and receive data. The operator remotely operates the construction machine by operating various levers provided at the remote operation mechanism while recognizing an image and sound of surroundings of the construction machine, which are output from the remote operation device.

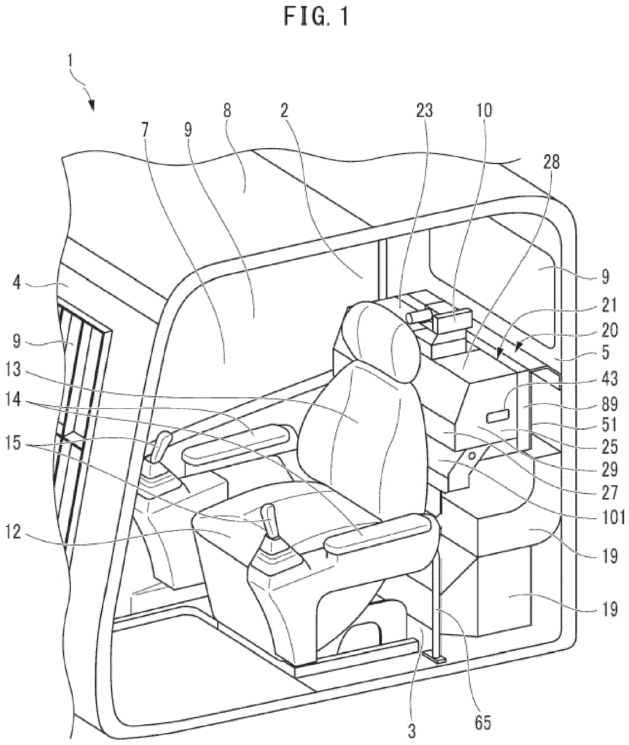

A cab 1 of the construction machine will be described below with reference to FIGS 1 to 3. Although the construction machine is not entirely illustrated, the present invention is applicable to a construction machine of any kind, which comprises a cab provided with a seat back side space on the back side of a seat. The construction machine is, for example, a crawler shovel. The present invention is also applicable to various construction machines such as a crane, a hydraulic pressure breaker, a nibbler, and a demolition machine. The construction machine comprises a lower carrier body of a crawler type and an upper rotation body rotatably mounted on the lower carrier body. A work mechanism including a boom, an arm, and a bucket is provided at a front central part of the upper rotation body. The cab 1 is provided at a front left part of the upper rotation body. In a remotely operable state with a remote operation electronic device comprised, the construction machine can be maneuvered by a pilot on board. Note that, in the following description, front, back, right, left, and up, and down directions of each member or the like are the same as the corresponding directions of an operating cab 2.

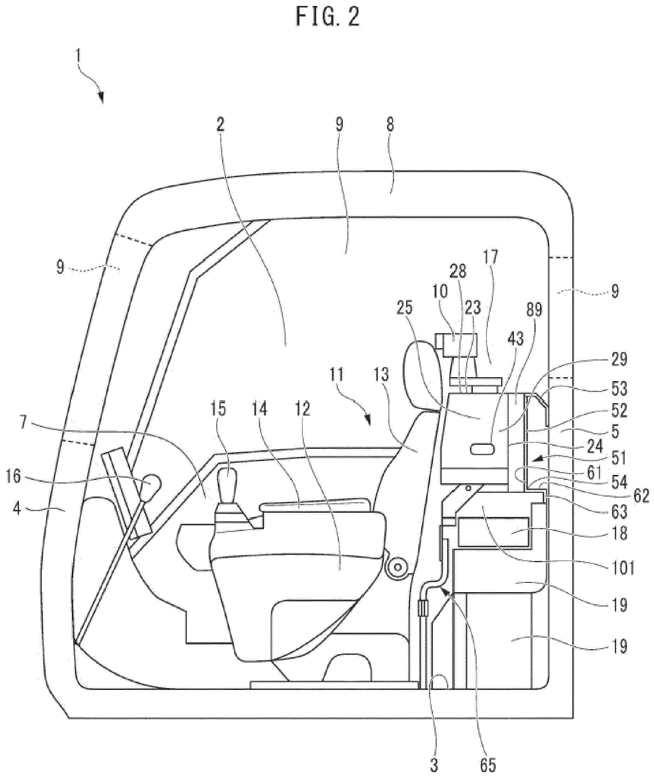

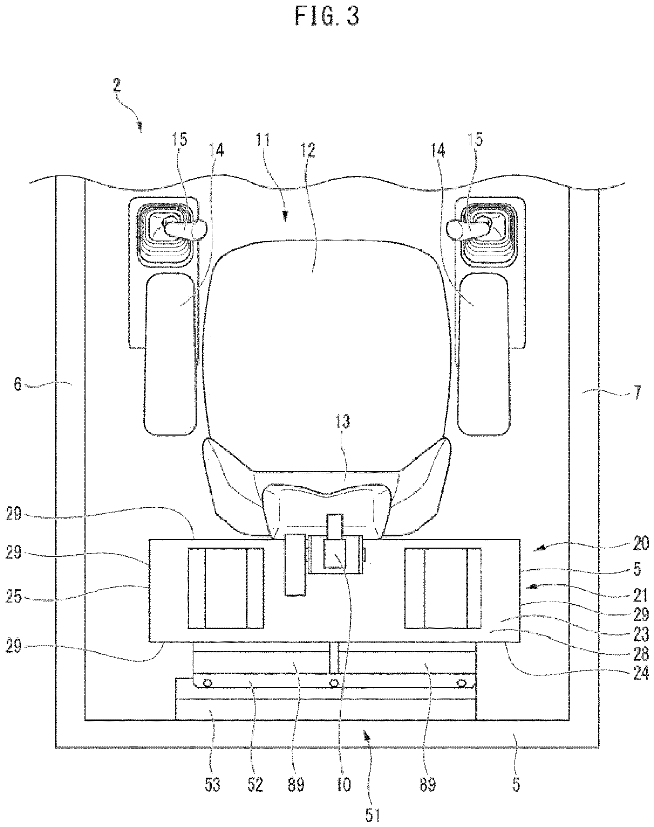

FIG. 1 is a perspective view illustrating the operating cab 2 from which a left side part of the cab 1 is omitted. FIG. 2 is a left side view of the operating cab 2 in FIG. 1. FIG. 3 is a top view of the operating cab 2 in FIG. 1 with its roof omitted.

The cab 1 is disposed on a frame of the upper rotation body. The cab 1 is formed in a box shape as a whole by combining a plurality of plate members. The cab 1 has a floor 3, an operating cab front part 4, an operating cab back part 5, an operating cab left side part 6, an operating cab right side part 7, and a roof part 8. The operating cab left side part 6 is provided with a non-illustrated door for a pilot to get on and off the construction machine. In FIG. 1, the operating cab left side part 6 of the cab 1 is omitted to facilitate understanding of inside of the operating cab 2. The operating cab front part 4, the operating cab back part 5, the operating cab left side part 6, and the operating cab right side part 7 are each provided with one or more windows 9. Each window 9 provided at the operating cab back part 5 allows visual recognition of the back side of the operating cab 2 and serves as an emergency exit for the pilot to get out of the operating cab 2 in case of emergency, for example, when the construction machine is overturned.

A seat 11 is provided in the cab 1 and is disposed at a position substantially center of the cab 1 in the right-left direction and slightly closer to the back side in the front-back direction. The seat 11 is used when the pilot on board maneuvers the construction machine that can be remotely operated. The seat 11 has a seating part 12, a backrest part 13, and armrests 14 and 14 provided on the right and left sides, respectively, of the seating part 12. The angle of the backrest part 13 can be adjusted within predetermined ranges toward the front and back sides, respectively, about a lower end part of the backrest part 13 coupled to the seating part 12 from an upright state relative to the seating part 12. For example, the backrest part 13 can be inclined toward the back side from the upright state so that the pilot can have a posture in which the pilot can easily perform operation. In addition, the backrest part 13 can be inclined toward the front side from the upright state to facilitate maintenance, attachment, and detachment of an instrument or a structural object on the back side of the seat 11.

Operation levers 15 and 15 are provided on the front side of the right and left armrests 14 and 14, respectively. With the operation levers 15 and 15, various operations of the construction machine, for example, a rotation operation of the upper rotation body, a boom operation, an arm operation, and a bucket operation are performed. In addition, traveling levers 16 corresponding to right and left crawlers, respectively, are disposed on the front side of the seat 11. The pilot on board the construction machine maneuvers the construction machine by operating these operation devices.

A seat back side space 17 is formed between the seat 11 and a back-side structural object disposed on the back side of the seat 11. The back-side structural object disposed on the back side of the seat 11 is, for example, the operating cab back part 5 constituting inner and outer walls of the cab 1. Alternatively, in a case where a wall-shaped structural object is disposed on the back side of the seat 11 in addition to the operating cab back part 5, depending on the construction machine, the structural object can be the back-side structural object. The back-side structural object can form the seat back side space 17 adjacent to the seat 11 and above a lower structural object to be described later. An electronic device housing module 20 in which an electronic device for performing remote operation of the construction machine is housed is provided in the seat back side space 17.

In the seat back side space 17, a structural object 19 is disposed on the floor 3. A fuse box 18 is disposed on the structural object 19. The lower structural object includes the fuse box 18, the structural object 19, and the floor 3. The lower structural object is a structural object positioned below a housing 21 installed in the seat back side space 17, and is an object on which the housing 21 is supported with a space therebetween. The housing 21 is supported such that the height of its upper surface is equal to or lower than the height of a lower end part of a window 9.

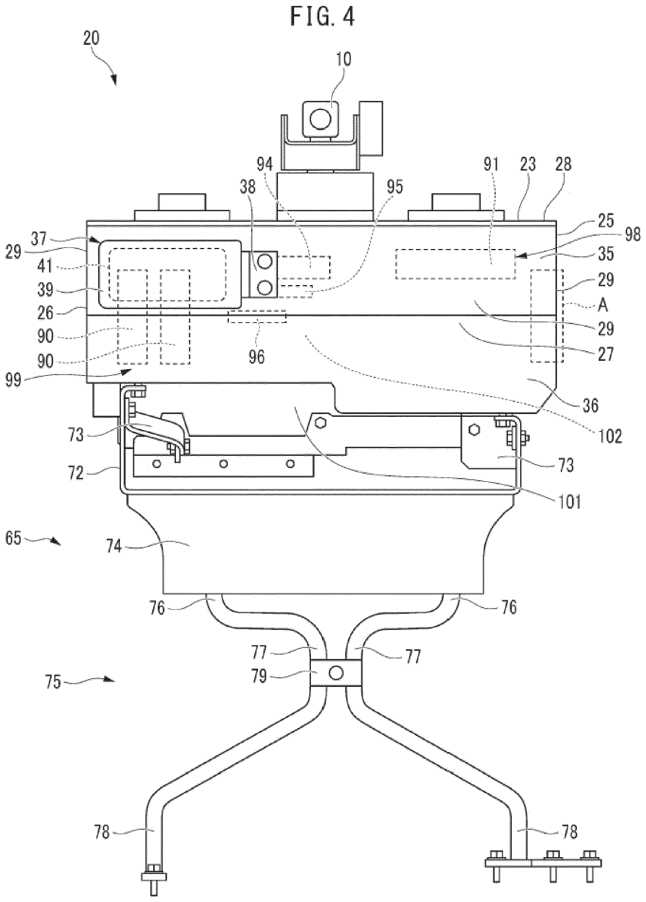

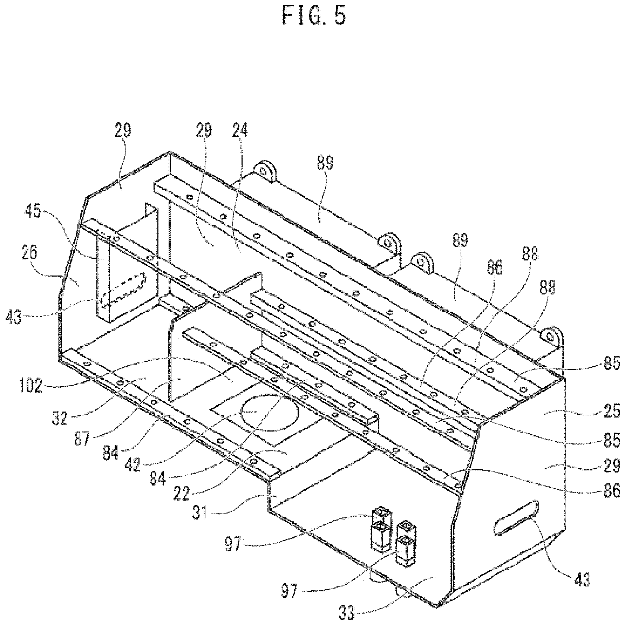

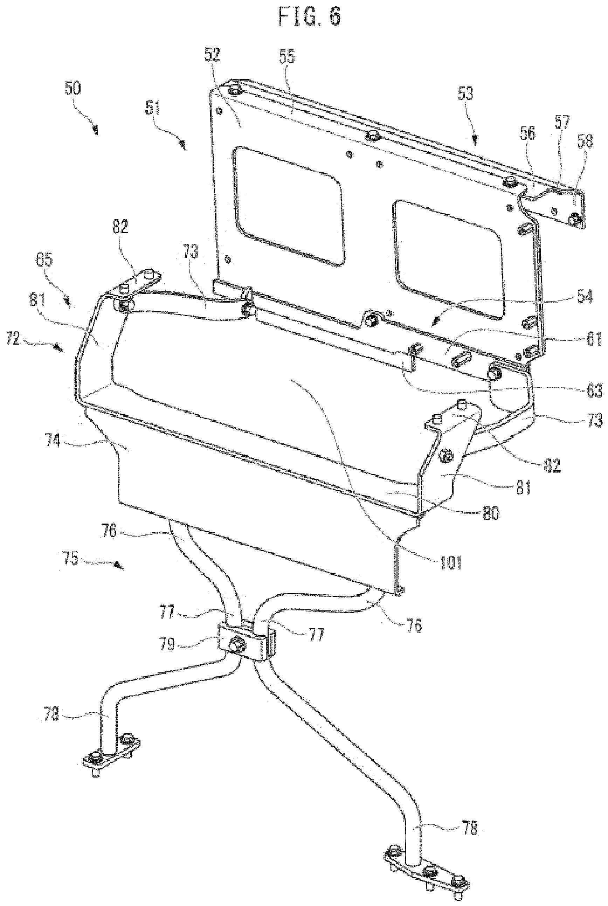

The electronic device housing module 20 will be described below with reference to FIGS 4 to 6. FIG. 4 is a front view of the electronic device housing module 20. FIG. 5 is a perspective view of the housing 21 included in the electronic device housing module 20. Note that, in FIG. 5, the upper and front surfaces of the housing 21 and the electronic device housed therein are omitted in illustrations. FIG. 6 is a perspective view of a fixation element 50 included in the electronic device housing module 20.

The electronic device housing module 20 comprises, in the seat back side space 17 between the seat 11 and the back-side structural object, the fixation element 50 for supporting with a space between the housing 21 in which the electronic device is housed and the lower structural object below the housing 21.

The housing 21 is a member formed in a box shape with a plurality of plate members to divide the inside and outside of the housing 21 from each other through the plate members, thereby preventing powder dust and the like from entering the inside of the housing 21. The housing 21 is formed substantially in a rectangular parallelepiped shape with a lower wall part 22, an upper wall part 23, and a plurality of side wall parts 29, and the side wall parts 29 include a first wall part, a second wall part, a third wall part, and a fourth wall part. The housing 21 is disposed in the seat back side space 17 such that a longitudinal direction of the housing 21 is aligned with the right-left direction of the operating cab 2. The housing 21 is connected to the fixation element 50 on the lower and back sides of the housing 21. In addition, an image capturing device 10 configured to capture an image of the front side of the operating cab 2 is disposed on the upper side of the housing 21.

The housing 21 includes the lower wall part 22 that defines the lower side of the housing 21, an upper front wall part 28 that defines the upper and front sides thereof, a back wall part 24 that defines the back side thereof, a left wall part 25 that defines the left side thereof, and a right wall part 26 that defines the right side thereof. The above-described first to fourth wall parts each correspond to any of the front, back, right, and left side wall parts 29. For example, the first wall part is the left wall part 25, the second wall part is the right wall part 26, the third wall part is a front wall part 27 of the upper front wall part 28, and the fourth wall part is the back wall part 24. Alternatively, the first wall part may be the left wall part 25, the second wall part may be the front wall part 27, the third wall part may be the right wall part 26, and the fourth wall part may be the back wall part 24. Alternatively, the first wall part may be the left wall part 25, the second wall part may be the back wall part 24, the third wall part may be the right wall part 26, and the fourth wall part may be the front wall part 27.

The lower wall part 22 will be described below with reference to FIGS 4 and 5. The upper end of the fixation element 50 is fixed to left and right end parts of the lower surface of the lower wall part 22. The lower wall part 22 is provided with a stepped part 31 on the left side of a central region between left and right end parts of the lower wall part 22. The lower wall part 22 includes an upper plate part 32 on the right side of the stepped part 31, and a lower plate part 33 on the left side thereof. The upper plate part 32 and the lower plate part 33 are plate-shaped members. The upper and lower surfaces of the upper plate part 32 and the lower plate part 33 are parallel to each other, and the upper plate part 32 is provided at a higher position relative to the lower plate part 33. With the above-described structure, the lower surface of the lower wall part 22 (outside of the housing 21) and the upper surface of the lower wall part 22 (inner surface side of the housing 21) each have a step.

Since the upper plate part 32 of the lower wall part 22 is formed higher than the lower plate part 33, a space of a volume by which the lower wall part 22 of the housing 21 is risen is provided at a part formed by rising the lower wall part 22 by the upper plate part 32 of the housing 21 as compared to a case where the lower wall part 22 is formed of the lower plate part 33 only. The fuse box 18 of the construction machine is provided on the lower side of the housing 21. As well known, fuse inspection and replacement are performed as maintenance work. With the electronic device support mechanism of the present invention, a maintenance worker can easily put a hand on the lower side of the housing 21. Thus, the electronic device support mechanism of the present invention can ensure high maintainability.

Since the lower plate part 33 of the lower wall part 22 is formed lower than the upper plate part 32, part of the upper surface of the lower wall part 22 on the inside of the housing 21 can be formed lower than the upper plate part 32, and accordingly, the internal space of the housing 21 can be increased. Moreover, since the up-down dimension of the inside of the housing 21 can be increased, the freedom of arrangement of the electronic device at a part of the internal space of the housing 21, which is large in the up-down direction can be increased. For example, it is possible to ensure dimensions for housing a PC having a relatively large height dimension, and it is possible to facilitate attachment and detachment of a PC that is attached as necessary. In addition, maintenance of the electronic device disposed inside the housing 21 can be facilitated further. Accordingly, the electronic device support mechanism of the present invention can increase the freedom of arrangement of the electronic device in the internal space of the housing 21 and can ensure high maintainability.

The lower wall part 22 is provided with one fan 42 configured to send air to the central region between left and right end parts of the lower wall part 22 and a left end part of the upper plate part 32. The fan 42 takes, into the housing 21, air in a space on the lower side of the upper plate part 32 outside the housing 21. The fan 42 is provided with a filter. Note that the rotational direction of a motor included in the fan 42 may be changed so that air inside the housing 21 is discharged to the space on the lower side of the upper plate part 32 outside the housing 21.

The upper front wall part 28 will be described below with reference to FIGS 1 and 4. The upper front wall part 28 includes the upper wall part 23 and the front wall part 27. The upper wall part 23 and the front wall part 27 are members that define an upper part (the upper surface) and a front part (front surface) of the housing 21, respectively. The upper wall part 23 and the front wall part 27 may be each individually formed, but in the present embodiment, the upper wall part 23 and the front wall part 27 are integrally formed as the upper front wall part 28 with their end parts connected to each other. The image capturing device 10 is installed on the upper front wall part 28. The image capturing device 10 captures an image of the front side of the operating cab 2 from inside the operating cab 2. The image captured by the image capturing device 10 is transmitted to the remote operation device. The operator remotely operates the construction machine while visually recognizing the image received and displayed by the remote operation device. Thus, the image capturing device 10 is installed above and at the center of the upper wall part 23 such that the height of a lens of the image capturing device 10 is substantially equal to the height of the eyes of a sitting pilot to allow the operator to easily visually recognize the front side.

The front wall part 27 includes a first front wall part 35 provided at the upper half of the front wall part 27, and a second front wall part 36 provided at the lower half thereof. The first front wall part 35 and the second front wall part 36 are formed of plate members having the same dimension in the right-left direction and having a rectangular shape with long sides substantially equal to the dimension of the housing 21 in the right-left direction. The first front wall part 35 and the second front wall part 36 are attached to the housing 21 in a state in which the long side of the upper wall part 23 on the front side and the long side of the first front wall part 35 on the upper side are connected to each other with a predetermined angle between the outer surfaces of the front wall parts.

The integrally formed upper front wall part 28 is fixed to the left wall part 25 and the right wall part 26 by a plurality of non-illustrated fixation holes and bolts provided at each of the left and right ends of the upper front wall part 28. The upper front wall part 28 can be removed from the housing 21 by loosening the bolts. Since the upper front wall part 28 blocking the upper and front sides of the housing 21 is integrally formed, the upper and front sides of the housing 21 can be opened all at once by removing only the upper front wall part 28 as one member. Thus, the inside of the housing 21 can be easily visually recognized to perform maintenance.

The upper front wall part 28 is attached to the housing 21 in a state in which the outer surface of the second front wall part 36 is tilted slightly upward relative to the vertical direction. A predetermined angle between the upper wall part 23 and the first front wall part 35 has a range of 100° to 140° and is, for example, 120°. A predetermined angle between the first front wall part 35 and the second front wall part 36 has a range of 130° to 170° and is, for example, 150°. The above-described predetermined angles are each determined as appropriate by the shape and size of the backrest part 13 of the seat 11, the shape and size of the seat back side space 17, and the like. Since the first front wall part 35 is formed as a tilt surface angled relative to a vertical line, an angle at which the backrest part 13 of the seat 11 is inclined without interfering with the housing 21 when the backrest part 13 is inclined toward the back side can be increased as compared to a case where the first front wall part 35 is not formed as a tilt surface. Thus, the pilot on board the construction machine can adjust the angle of the backrest part 13 to an optimum maneuvering posture.

An open-close part 37 is provided at the first front wall part 35. The open-close part 37 is a member with which part of the first front wall part 35 can be easily opened. The open-close part 37 includes a hinge 38 and an open-close plate 39 held freely openable and closable by the hinge 38. The hinge 38 is fixed at an adjacent site on the first front wall part 35 provided with an inspection opening 41, the adjacent site being on the left side of the inspection opening 41. By opening the open-close plate 39, a maintenance worker can easily visually recognize a lamp and the like indicating a signal transmission-reception state of the electronic device disposed near the inspection opening 41 inside the housing 21. Accordingly, with the open-close part 37 provided, it is possible to facilitate maintenance work of the housing 21.

The left wall part 25 and the right wall part 26 will be described next with reference to FIGS 4 and 5. The left wall part 25 and the right wall part 26 disposed on the left and right sides of the housing 21, respectively, are formed symmetric with respect to the center of the housing 21 in the right-left direction. Each wall part is fixed to a left or right side end part of each of the lower wall part 22, the upper front wall part 28, and the back wall part 24 by a non-illustrated fixation member. An opening part of a vent 43 is provided in each of regions at the lower ends of the left wall part 25 and the right wall part 26 and at the centers thereof in the front-back direction. The opening part of the vent 43 is a rectangular hole elongated in the front-back direction, and the length thereof in the front-back direction is approximately 1/3 of the left wall part 25 and the right wall part 26.

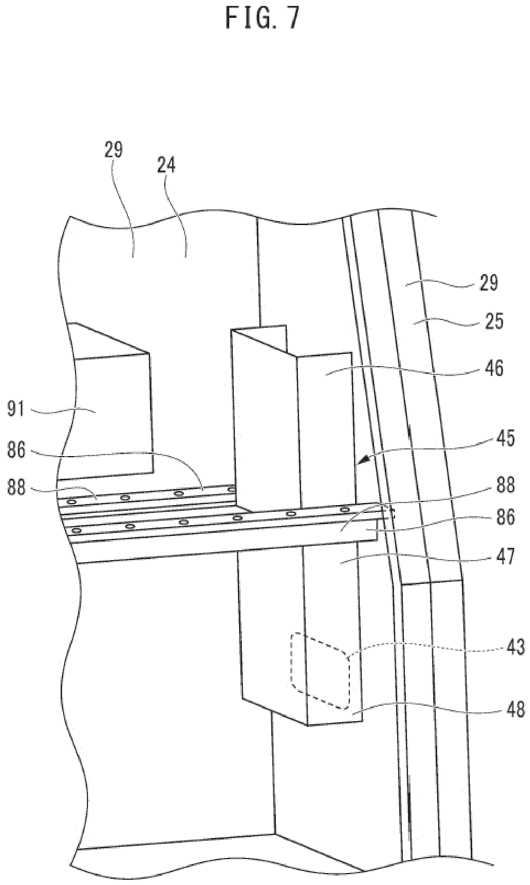

An airflow adjustment member 45 comprised in the housing 21 and provided at each of the inner surfaces of the left wall part 25 and the right wall part 26 will be described below with reference to FIG. 7. FIG. 7 is a partially enlarged diagram of part A in FIG. 4. The vents 43 are opening parts and provided at the left wall part 25 and the right wall part 26. The airflow adjustment members 45 are provided on the inner surfaces of the left wall part 25 and the right wall part 26 to cover the vents 43. The airflow adjustment members 45 are members that reduce powder dust, foreign objects, and the like entering from the outside of the housing 21 to the inside through the vents 43 so that air efficiently flows to the vents 43. Each airflow adjustment member 45 is a member formed by bending a plate member and having a U-shaped section. The airflow adjustment members 45 are fixed to the inner surfaces of the left wall part 25 and the right wall part 26, respectively, such that an air flow path through which air flows in the up-down direction is formed by each airflow adjustment member 45 in a U-shaped section and the inner surface of the left wall part 25 or the right wall part 26.

The dimension of the inside of each airflow adjustment member 45 in the front-back direction is equal to or larger than the dimension of each vent 43 in the front-back direction. The dimension of the inside of each airflow adjustment member 45 in the front-back direction is one to two times larger than the dimension of each vent 43 in the front-back direction, and is, for example, the same. The dimension of each airflow adjustment member 45 in the up-down direction is two to four times larger than the dimension of each vent 43 in the up-down direction and is, for example, three times larger. Accordingly, the airflow adjustment members 45 cover the entire vents 43 on the inner surfaces of the left wall part 25 and the right wall part 26.

Each airflow adjustment member 45 includes an upper part 46, a middle part 47, and a lower part 48 and is integrally formed. The upper part 46 is a member having an opened upper part and communicating with the inside of the housing 21. The middle part 47 is connected to the upper part 46, does not communicate with the inside of the housing 21, and forms a flow path with the inner surface of the left wall part 25 and the right wall part 26. The lower part 48 is a member connected to the middle part 47, having an opened lower part, and communicating with the inside of the housing 21. The lower part 48 is provided at a position at least partially overlapping the vent 43 on the inner surface of the left wall part 25 and the right wall part 26 in a side view of the housing 21, and the air flow path inside the lower part 48 communicates with the outside of the housing 21 through the vent 43.

The back wall part 24 will be described below with reference to FIG. 5. The back wall part 24 is a member blocking the back surface of the housing 21. At the back surface of the back wall part 24, two remote operation controllers 89 and 89 are fixed side by side in contact with the back wall part 24. Note that each controller 89 may be disposed at another site and a housing fixation member to be described later may be directly fixed to the back wall part 24.

The fixation element 50 will be described below with reference to FIGS 4 and 6. The fixation element 50 includes a housing fixation part 51 that fixes the housing 21 to the operating cab back part 5 as the back-side structural object and holds the housing 21 from a side surface, and a leg part 65 that holds the housing 21 from the lower side.

The housing fixation part 51 includes a first member 52, a second member 53, and a third member 54. The first member 52 is a member that is fixed in close contact to the back surfaces of the controllers 89 and 89 fixed to the back wall part 24 of the housing 21 and to which the second member 53 fixed to the operating cab back part 5 as the back-side structural object and the third member 54 are connected. The first member 52 is a rectangular member formed of a plate member, and the dimensions of the long and short sides of the first member 52 are substantially equal to the dimensions of the long and short sides of the back wall part 24. The first member 52 is provided with four screw holes in each of horizontal lines adj acent to upper and lower end parts of the first member 52 and is fixed to the back wall part 24 by bolts. The upper end part of the first member 52 is bent at right angle to the surface of the first member 52 to form a first member horizontal part 55. Note that the controllers 89 and 89 do not necessarily need to be disposed in contact with the housing 21, and thus the controllers 89 and 89 may be fixed at sites separated from the housing 21. In this case, the first member 52 is directly fixed to the back wall part 24.

The second member 53 is a member coupling the first member 52 and the operating cab back part 5 as the back-side structural object on the upper side of the first member 52. The dimension of the second member 53 in the right-left direction is substantially equal to the dimension of the first member 52 in the right-left direction, and the second member 53 is formed by disposing a rectangular plate member with its longitudinal direction aligned with the right-left direction and bending the plate member along bending lines parallel to each other in the right-left direction. The second member 53 includes a second member horizontal part 56, a second member tilt part 57, and a second member vertical part 58 in the stated order from the housing 21 side toward the operating cab back part 5 side. The second member horizontal part 56 and the first member horizontal part 55 are attached to each other with their surfaces in contact and are fixed by bolts and nuts through a plurality of bolt holes provided at the horizontal parts. The second member vertical part 58 is provided with a plurality of bolt holes and fixed to the operating cab back part 5 as the back-side structural object by bolts and nuts. The second member tilt part 57 is positioned between the second member horizontal part 56 and the second member vertical part 58 and couples the parts.

The third member 54 is a member coupling the first member 52 and the operating cab back part 5 as the back-side structural object on the lower side of the first member 52. The third member 54 is formed by disposing a rectangular plate member with its longitudinal direction aligned with the right-left direction and bending the plate member along bending lines parallel to each other in the right-left direction. The third member 54 includes a third member front surface part 61, a non-illustrated third member middle part 62, and a third member back surface part 63 in the stated order from the housing 21 side toward the operating cab back part 5 side. The dimension of the third member front surface part 61 in the right-left direction is substantially equal to the dimension of the first member 52 in the right-left direction. The third member front surface part 61 is attached at the lower end part of the first member 52 with its surface in contact with the surface of the first member 52 and are fixed by bolts and nuts through a plurality of bolt holes provided at the components. Note that, in addition to FIGS 4 and 6, FIG. 2 illustrates the third member front surface part 61, the third member middle part 62, and the third member back surface part 63.

The third member back surface part 63 is provided with a plurality of bolt holes and fixed to the operating cab back part 5 as the back-side structural object by bolts and nuts. The third member middle part 62 is positioned between the third member front surface part 61 and the third member back surface part 63 and couples the surface parts. The dimensions of the third member middle part 62 and the third member back surface part 63 in the right-left direction are about half of the dimension of the first member 52 in the right-left direction, and the third member front surface part 61 is connected to the third member middle part 62 through a connection part formed with a smoothly changing dimension in the width direction. The third member middle part 62 and the third member back surface part 63 are disposed such that the positions of the right ends of the third member middle part 62 and the third member back surface part 63 in the right-left direction are substantially aligned with the position of the right end of the first member 52 in the right-left direction.

Note that, in the above description, the dimensions of the third member middle part 62 and the third member back surface part 63 in the right-left direction are about half of the dimension of the housing 21 in the right-left direction due to constraints on the size of a fixation site of the operating cab back part 5, but may be changed as appropriate. The dimensions of the parts in the right-left direction may be larger and may be, for example, substantially equal to the dimension of the first member 52 in the right-left direction. In this case, the housing 21 that is a heavy weight object can be more reliably fixed to the operating cab back part 5 as the back-side structural object, and thus the fixed state of the housing 21 can be more reliably maintained when vibration is repeatedly applied to the housing 21 during work with the construction machine.

The leg part 65 will be described below with reference to FIGS 4 and 6. The leg part 65 is a member supporting the lower side of the housing 21 such that the housing 21 is disposed with a space adjacent to the lower structural object. The leg part 65 includes a fourth member 72 connected to the lower surface of the housing 21, a fifth member 73 connecting the fourth member 72 and the housing fixation part 51, a sixth member 74 connected to the lower surface of the fourth member 72, and a seventh member 75 having an upper end connected to the sixth member 74 and holding the housing 21 at a predetermined height.

The fourth member 72 includes a fourth member horizontal part 80, fourth member vertical parts 81 provided at respective end parts of the fourth member horizontal part 80, and fourth member fixation parts 82 provided at end parts of the fourth member vertical parts 81, respectively, on a side opposite the fourth member horizontal part 80. The fourth member horizontal part 80 is a plate member having a constant dimension in the front-back direction and a dimension in the right-left direction substantially equal to the dimension of the housing 21 in the right-left direction. The two fourth member vertical parts 81 have the same size and the same shape. The fourth member vertical parts 81 are members intersecting each other at approximately 45° in a substantially L shape in a side view parallel to the right-left direction. Lower end parts of the respective fourth member vertical parts 81 are fixed to respective end parts of the fourth member horizontal part 80. The fourth member fixation parts 82 are connected to upper end parts of the fourth member vertical parts 81, respectively. The fourth member fixation parts 82 extend in directions at right angle to the fourth member vertical parts 81 and form horizontal planes part. The fourth member fixation parts 82 are provided with fixation members such as bolts and connected to the lower surfaces of respective end parts of the lower wall part 22 in the right-left direction.

A space 101 is provided adjacent to the lower surface of the housing 21 on the lower side of the housing 21. The fourth member 72 is provided on the lower side of the housing 21 to enclose the space 101 on the lower side of the housing 21. The area of the space 101 in the horizontal direction is substantially equal to the area of the lower surface of the housing 21 in the horizontal direction. Since the space 101 is provided on the lower side of the housing 21, no member is adj acent to the fan 42 provided at the lower wall part 22. Thus, air intake into the housing 21 or discharge from the housing 21 by the fan 42 can be efficiently performed without interference with any other member. As illustrated in FIG. 2, the fuse box 18 comprised in the construction machine is disposed on the lower side of the housing 21 with the space 101 interposed therebetween. Since the space 101 is formed on the lower side of the housing 21, a worker can easily perform maintenance of the fuse box 18. The space 101 includes a central region on the lower surface of the housing 21 where the fan 42 is positioned. The area of the space 101 in the horizontal direction is equal to or larger than at least half of the area of the lower surface of the housing 21 in the horizontal direction.

Each fifth member 73 is a plate member connecting the fourth member 72 and the housing fixation part 51. Each fifth member 73 has one end connected to the corresponding one of the fourth member vertical parts 81, and the other end connected to the corresponding one of left and right end parts of the third member 54 at a lower end part of the housing fixation part 51.

The sixth member 74 is a member fixed to the lower surface of the fourth member 72 and holding the seventh member 75. The sixth member 74 is a substantially rectangular plate member, and end parts of the long sides are bent at right angle. One of the bent end parts of the sixth member 74 is connected to the lower surface of the fourth member 72, and the sixth member 74 is perpendicularly fixed to the fourth member 72.

The seventh member 75 is a member fixed to the sixth member 74 and holding the housing 21 at a predetermined height. The seventh member 75 is constituted by combining two solid longitudinal members having sections in circular outer shapes. The seventh member 75 includes a seventh member upper part 76, a seventh member middle part 77, a seventh member lower part 78, and a coupling part 79.

The seventh member 75 is constituted by combining two same members. The seventh member upper part 76 and the seventh member lower part 78 are formed substantially straight. The seventh member middle part 77 connecting the parts is formed in a substantially U shape in a front view. The vicinity of an upper end part of the seventh member middle part 77 is bent by 90° from the seventh member lower part 78 side toward the back side in a side view and again bent upward such that the upper end part of the seventh member middle part 77 faces upward. The two members of the seventh member 75 are combined such that the convex parts of the U-shaped seventh member middle parts 77 of the members are close to each other, and the convex parts are coupled to each other through the coupling part 79. A plate-shaped fixation part is provided at a lower end part of each seventh member lower part 78 and fixed to the floor 3 by bolts. Note that the seventh member 75 may be a hollow circular tube member instead of a solid member. In this case, fabrication is easier than in a case of the solid member, and weight reduction and cost reduction can be achieved.

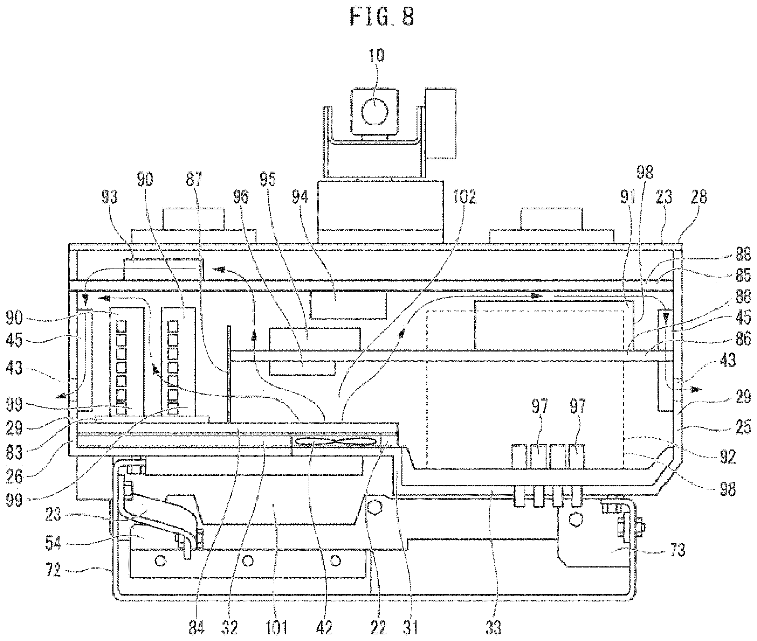

The structure inside the housing 21 will be described below with reference to FIGS 5 and 8. The housing 21 comprises a placement part 88 and a fixation plate 87 inside the housing 21 to achieve efficient housing of the electronic device in the housing 21. The placement part 88 is a member supporting the electronic device and includes first support members 85 and 85, second support members 86 and 86, and third support members 84 and 84. The fixation plate 87 is a plate-shaped member supporting and fixing one end part of the placement part 88. The fixation plate 87 fixes one end of each of the second support members 86 and 86. The fixation plate 87 is a substantially rectangular plate member and perpendicularly attached on an upper part 32 of the lower wall part 22. The fixation plate 87 is provided in parallel to the left wall part 25 at a position separated from the left wall part 25 by approximately 2/3 to 3/4 of the dimension of the housing 21 in the right-left direction.

The first support members 85 and 85, the second support members 86 and 86, and the third support members 84 and 84 are longitudinal members supporting the electronic device in the housing 21. The first support members 85 and 85 and the second support members 86 and 86 are, for example, longitudinal angle members having L-shaped sections and each formed by bending a longitudinal plate member at right angle along one bending line parallel to the longitudinal direction. The first support members 85 and 85 and the second support members 86 and 86 are the same members each formed in a necessary length. The third support members 84 and 84 are, for example, longitudinal channel members having U-shaped or C-shaped sections and formed by bending both end parts of a longitudinal plate member along two bending lines parallel to the longitudinal direction.

The first support members 85 and 85, the second support members 86 and 86, and the third support members 84 and 84 are each provided with circular holes that are bolt holes for fixation of the electronic device at constant intervals across the entire length of a flat plate part included in the support member. The first support members 85 and 85 and the second support members 86 and 86 have L-shaped sections each have circular holes across the entire length of its flat plate part horizontally disposed in the housing 21. The third support members 84 and 84 form groove bottoms of channel members having U-shaped or C-shaped sections and are each provided with circular holes across the entire length of its flat plate part horizontally disposed in the housing 21. Since the first support members 85 and 85, the second support members 86 and 86, and the third support members 84 and 84 each have a plurality of circular holes that are fixation bolt holes substantially across the entire length, an attachment place of the electronic device can be selected and the electronic device can be easily attached. As a result, the electronic device can be disposed to form a flow path through which air efficiently flows in the housing 21. Note that the fixation bolt holes may be long holes instead of circular holes. In a case where the fixation bolt holes are long holes, fine adjustment of attachment position of the electronic device can be easily performed and thus the freedom of attachment can be increased as compared to the case of circular holes.

The two first support members 85 and 85 are stretched in parallel to each other at the same height between facing surfaces of the left wall part 25 and the right wall part 26 and each fixed with one of its plane parts horizontally positioned. The height at which the two first support members 85 and 85 are fixed is equal to approximately 1/5 to 1/4 of the length between the upper part 32 of the lower wall part 22 and the upper wall part 23 from the upper side. To maximize the interval between the two first support members 85 and 85, the first support member 85 on the back side is fixed at a position substantially in contact with the back wall part 24, and the first support member 85 on the front side is fixed at a position adj acent to front end sides of the left wall part 25 and the right wall part 26.

The two second support members 86 and 86 are stretched in parallel to each other at the same height between facing surfaces of the fixation plate 87 and the left wall part 25 and each fixed with one of its plane parts horizontally positioned. The height at which the two second support members 86 and 86 are fixed is positioned lower than the two first support members 85 and 85 and equal to approximately 1/2 to 1/3 of the length between the upper part 32 of the lower wall part 22 and the upper wall part 23. To maximize the interval between the two second support members 86 and 86, the second support member 86 on the back side is fixed at a position substantially in contact with the back wall part 24, and the second support member 86 on the front side is fixed at a position adjacent to front end sides of the fixation plate 87 and the right wall part 26.

The two third support members 84 and 84 are each fixed in parallel to the right-left direction across the entire length between the right wall part 26 and the stepped part 31 at front and back ends on the upper part 32 of the lower wall part 22. The third support members 84 and 84 are each fixed such that the opening part of its U shape or C shape is positioned the lower side and its plane part provided with circular holes is positioned on the upper side. Note that the third support members 84 and 84 may be fixed at other positions on the lower wall part 22, for example, on a lower part 33, and other third support members 84 and 84 may be provided in addition to the third support members 84 and 84 at the above-described positions.

The first support members 85 and 85, the second support members 86 and 86, and the third support members 84 and 84 serve as upper mounts, middle mounts, and lower mounts that are electronic device mounting positions that are different in the height direction inside the housing 21. The housing 21 has an upper mount, a middle mount, and a lower mount at a left side part (the left wall part 25 side) of the housing 21, has an upper mount and a middle mount except for a gap 102 directly above the fan 42 at a central part, and has an upper mount and a lower mount at a right side part (the right wall part 26 side). For example, the following disposition of electronic devices is possible on the upper, middle, and lower mounts. A small-sized electronic device is mounted on an upper mount. An electronic device is mounted on a middle part while the gap 102 directly above the fan 42 is ensured. A relatively large electronic device among disposed electronic devices is mounted on a lower mount. With the above-described disposition method, the gap 102 directly above the fan 42 can be ensured, a relatively largely heavy electronic device can be reliably fixed on the lower wall part 22, and a relatively small-sized electronic device can be fixed on an upper mount or a middle mount of the housing 21 where attachment and detachment are easy. Moreover, with the above-described disposition method, a gap can be ensured between electronic devices on upper and middle mounts and a flow path through which air flows can be formed. Note that the numbers of the first support members 85 and 85, the second support members 86 and 86, and the third support members 84 and 84, their positions in the up-down direction, and their fixation positions in the front-back direction may be changed as appropriate in accordance with the kinds and number of mounted electronic devices.

Electronic device disposition in the housing 21 will be described below with reference to FIG. 8. A second electronic device group 99 is disposed on the inner side of the right wall part 26 with a gap from the right wall part 26. The gap includes a space part defined by an airflow adjustment member 45. The second electronic device group 99 is, for example, switching hubs 90 and 90. The switching hubs 90 and 90 are disposed between the right wall part 26 and the fixation plate 87 such that the longitudinal directions of the switching hubs 90 and 90 are aligned with the front-back direction and the switching hubs 90 and 90 are parallel to each other. The switching hubs 90 and 90 are fixed on a support plate 83 stretched between and attached on the two third support members 84 and 84 attached to the upper part 32 of the lower wall part 22. The support plate 83 is provided with circular holes that are bolt holes for fixation to the two third support members 84 and 84 and circular holes that are bolt holes for fixation of the switching hubs 90 and 90, and is fixed on the third support members 84 and 84 by a non-illustrated fixation member. The switching hubs 90 and 90 are fixed to the support plate 83 by a non-illustrated fixation member. The switching hubs 90 and 90 are disposed in an orientation in which their longitudinal directions are aligned with the front-back direction, and the front surfaces of the switching hubs 90 and 90 are positioned on the front wall part 27 side of the housing 21. Thus, actuation lamps and the like of the switching hubs 90 and 90 can be visually recognized when the open-close plate 39 provided at the front wall part 27 is opened, and thus the operational statuses of the switching hubs 90 and 90 can be easily understood. The number of electronic devices included in the second electronic device group 99 may be not only plural but also one, and the second electronic device group 99 in the present specification means one or more electronic devices. Note that the second electronic device group 99 includes an electronic device that does not satisfy environment resistance (heat dissipation and dust protection) alone.

A first electronic device group 98 is disposed on the inner side of the left wall part 25 in the housing 21 and on the second support members 86 and 86 with an interval from the left wall part 25. The gap includes a space part defined by an airflow adjustment member 45. The first electronic device group 98 is, for example, an encoder 91. The number of electronic devices included in the first electronic device group 98 may be not only plural but also one, and the first electronic device group 98 in the present specification means one or more electronic devices. Note that the first electronic device group 98 includes an electronic device that does not satisfy environment resistance (heat dissipation and dust protection) alone.

A PC 92 as another example of the first electronic device group 98 may be mounted in the housing 21. The PC 92 mounted in the housing 21 is illustrated with dashed lines in FIG. 8. The PC 92 may be mounted at any place in the housing 21, but the PC 92 can be easily installed when placed on the lower part 33 of the lower wall part 22 at the right side part of the housing 21, which is formed with a large dimension in the up-down direction in the housing 21. The PC 92 is disposed at a position adj acent to the left wall part 25 on the lower part 33 with an interval from the left wall part 25 and sandwiched between the two second support members 86 and 86. In a case where the PC 92 is mounted at the position, the encoder 91 is fixed at a position different from the above description. The second electronic device group 99 is an electronic device disposed adjacent to the left wall part 25, for example, the encoder 91 or the PC 92.

At the first support members 85 and 85 adjacent to the right wall part 26, a LAN relay 93 is fixed on the upper side of the first support members 85 and 85 with an interval from the right wall part 26. At the second support members 86 and 86 adjacent to the fixation plate 87, a voice encoder 95 and a video encoder 96 are fixed on the upper and lower sides, respectively, of the second support members 86 and 86 with a slight interval from the fixation plate 87. At the first support members 85 and 85, an amplifier 94 is fixed on the lower side of the first support members 85 and 85 substantially at the center of the housing 21 in the right-left direction with an interval from the fixation plate 87.

Each electronic device is fixed to the first support members 85 and 85, the second support members 86 and 86, or the third support members 84 and 84 through a plate-shaped longitudinal member such as the support plate 83 as necessary. Connectors 97 are disposed on the front side of the lower part 33 of the lower wall part 22. Although wires and the like are omitted in FIG. 8, electronic devices in the housing 21 are electrically connected to the outside of the housing 21 through the connectors 97.

An example of air flow that cools electronic devices in the housing 21 will be described below with reference to FIG. 8. In FIG. 8, main air flow, in other words, an air flow path is illustrated with arrows. The fan 42 is fixed at a position closer to the center of the housing 21 at the upper part 32 of the lower wall part 22 in the central region of the lower wall part 22. The vents 43 are provided at the left wall part 25 and the right wall part 26. The rotational direction of the fan 42 is set so that air is taken into the housing 21 from the space 101 at the lower wall part 22. Thus, the fan 42 can take in air from a space that is sandwiched between the seat 11 and the back-side structural object and powder dust is relatively unlikely to enter. Accordingly, the fan 42 can take air with a relatively small amount of powder dust into the housing 21. Note that the rotational direction of the fan 42 may be opposite to the above description and the rotational direction of the fan 42 may be set so that air is discharged from the inside of the housing 21 to the outside.

Air taken in by the fan 42 flows upward through the gap 102 directly above the fan 42 and then through gaps on the front, back, right, and left sides of the video encoder 96, the voice encoder 95, and the amplifier 94 directly above the fan 42. Part of the air flows to the right of the housing 21 along a front wall part 27 of the housing 21 and moves upward while passing by the front surface of the switching hubs 90 and 90. Part of the air flows to the left of the housing 21 along the front wall part 27 of the housing 21 and moves upward while passing by the front and back surfaces of the encoder 91 or the PC 92. The air having moved upward cools the LAN relay 93 in contact while flowing in the left or right direction and reaches the left wall part 25 or the right wall part 26 of the housing 21. Thereafter, the air passes through any of the airflow adjustment members 45 and is discharged from the corresponding vent 43.

In other words, air flow paths through which air having entered the housing 21 through the fan 42 installed at the lower wall part 22 passes through the gap 102 and flows in divided directions toward the left wall part 25 and the right wall part 26 from the central part of the housing 21 in the right-left direction are formed. The space between each airflow adjustment member 45 and the left wall part 25 or the right wall part 26 forms part of the corresponding air flow path. Each electronic device provided in the housing 21 is disposed in a route through which air flows. The first electronic device group 98 is disposed near the left wall part 25 and disposed in the route of the air flow path from the fan 42 to the left wall part 25. The second electronic device group 99 is disposed near the right wall part 26 and disposed in the route of the air flow path from the fan 42 to the right wall part 26. Accordingly, electronic devices that generate particularly large amounts of heat are separated and dispersedly disposed and are each disposed in a different air flow path to achieve efficient cooling.

According to the above-described embodiment, efficient ventilation can be performed with small fluid resistance between the inside and outside of the housing 21 in which the first electronic device group 98 and the second electronic device group 99 are housed. Thus, an electronic device that does not satisfy environment resistance (heat dissipation and dust protection) alone can be disposed to obtain sufficient environment resistance (heat dissipation and dust protection).

Part of the above-described embodiment may be replaced with modifications below.

In the above-described configuration, the housing 21 has a substantially rectangular parallelepiped shape and is formed such that the longitudinal direction of the housing 21 is aligned with the right-left direction of the operating cab 2. Instead, the housing 21 may be formed such that the longitudinal direction of the housing 21 is aligned with the front-back direction of the operating cab 2. The housing 21 may have a substantially cubic shape having substantially equal dimensions in the front-back direction and the right-left direction. The first electronic device group 98 and the second electronic device group 99 may be disposed in the right-left direction or the front-back direction in any of the above-described case where the housing 21 has a substantially rectangular parallelepiped shape and the longitudinal direction is aligned with the right-left direction, the above-described case where the housing 21 has a substantially rectangular parallelepiped shape and the longitudinal direction is aligned with the front-back direction, and the above-described case where the housing 21 has a substantially cubic shape. Alternatively, both members may be disposed with offset from each other in both the front-back direction and the right-left direction, in other words, such that straight lines passing through both members are not aligned with the front-back direction nor the right-left direction. For example, when the housing 21 is viewed from top, the first electronic device group 98 may be disposed on the front-left side and the second electronic device group 99 may be disposed on the back-right side. Alternatively, the first electronic device group 98 may be disposed on the back-left side and the second electronic device group 99 may be disposed on the front-right side.

In the above-described configuration, the housing 21 includes the fan 42 at the lower wall part 22 and includes the vents 43 at the left wall part 25 and the right wall part 26. Alternatively, the fan 42 may be disposed at any one or more of the lower wall part 22, the left wall part 25, the right wall part 26, the back wall part 24, the upper wall part 23, and the front wall part 27. In this case, the fan 42 is provided at a site on a wall part in contact with the gap 102 formed in the housing 21. Thus, efficient ventilation can be performed between the inside and outside of the housing 21. The vents 43 may be disposed at any one or more of the lower wall part 22, the left wall part 25, the right wall part 26, the back wall part 24, the upper wall part 23, and the front wall part 27 where the fan 42 is not disposed. The above-described variations of disposition of the fan 42 and the vents 43 are also applicable to any of the cases of the housing shapes described in the previous paragraph. The vents 43 are preferably disposed at least at the side wall parts 29 at sites adjacent to the first electronic device group 98 and the second electronic device group 99.

In any of the cases, dispositions of the fan 42 and the vents 43 may be interchanged. For example, a vent 43 may be provided at the lower wall part 22, and fans 42 may be provided at the left wall part 25 and the right wall part 26. Alternatively, one of a fan 42 and a vent 43 may be disposed at the lower wall part 22, and the other of the fan 42 and the vent 43 may be disposed at least one of the side wall parts 29. Alternatively, only one of a fan 42 and a vent 43 may be provided at the housing 21. Specifically, only one of a fan 42 and a vent 43 may be disposed at any one or more of the lower wall part 22, the left wall part 25, the right wall part 26, the front wall part 27, the back wall part 24, and the upper wall part 23. In a case where only the vent 43 is provided at the housing 21, the fan 42 may be provided inside the housing 21, for example, at a site at any of an upper part, a front part, a left side part, a right side part, and a back part of the gap 102 and supported by a non-illustrated fixation member. In this case as well, an air flow path is formed by the fan 42 and the vent 43, and electronic devices are disposed in the air flow path.

The position of a fan 42 or a vent 43 disposed at the lower wall part 22, at the lower wall part 22 may be other than the central region of the lower wall part 22. The position of the fan 42 or the vent 43 at the lower wall part 22 may be, for example, a middle part between the central region of the lower wall part 22 and the left wall part 25 where the first electronic device group 98 is disposed or the right wall part 26 where the second electronic device group 99 is disposed. Alternatively, the position of the fan 42 or the vent 43 at the lower wall part 22 may be near the right wall part 26 on a side opposite the left wall part 25 where the first electronic device group 98 is disposed, or may be near the left wall part 25 on a side opposite the right wall part 26 where the second electronic device group 99 is disposed. Alternatively, the position may be a position adjacent to the left wall part 25 where the first electronic device group 98 is disposed or the right wall part 26 where the second electronic device group 99 is disposed. The first electronic device group 98 and the second electronic device group 99 are preferably disposed in the route of an air flow path formed of the fan 42 and the vent 43.

In the above-described embodiment, the housing 21 includes the first electronic device group 98 and the second electronic device group 99. Only one of the electronic device groups, in other words, a single electronic device group may be provided. Specifically, the housing 21 may be provided with only the first electronic device group 98. Alternatively, the housing 21 may be provided with only the second electronic device group 99. In such a case, not a plurality of air flow paths divided into the right and left directions from the central part of the housing 21 need to be formed but at least one may be formed. The single electronic device group provided in the housing 21 is disposed in one air flow path formed between a fan 42 and a vent 43. For example, the fan 42 may be provided at the lower wall part 22, the vent 43 may be provided at any one or more of the side wall parts 29, and the electronic device group may be provided between the gap 102 directly above the fan 42 and the vent 43 at a side wall part 29. Alternatively, the fan 42 may be provided at the lower wall part 22, the vent 43 may be provided at the upper wall part 23, and the electronic device group may be provided adjacent to the upper wall part 23. In this case, an air flow path is formed in the up-down direction between the fan 42 at the lower wall part 22 and the vent 43 at the upper wall part 23, and the electronic device group is disposed in the route of the air flow path in the up-down direction.

For example, one of the fan 42 and the vent 43 may be disposed at the lower wall part 22, and the other of the fan 42 and the vent 43 may be disposed at one of the left wall part 25 where the first electronic device group 98 is disposed and the right wall part 26 where the second electronic device group 99 is disposed. One of the fan 42 and the vent 43 may be disposed at any one or more of the lower wall part 22, the left wall part 25, the right wall part 26, the back wall part 24, the upper wall part 23, and the front wall part 27, and the other of the fan 42 and the vent 43 may be disposed at any one or more of the lower wall part 22, the left wall part 25, the right wall part 26, the back wall part 24, the upper wall part 23, and the front wall part 27 where the fan 42 is not disposed. The fan 42 and the vent 43 thus disposed form at least one air flow path, and electronic devices disposed in the air flow path are cooled by air. Instead of the above-described case where the housing 21 is provided with the fan 42 and the vent 43, the housing 21 may be provided with only a plurality of vents 43.

In the above-described embodiment, the upper wall part 23 and the front wall part 27 of the housing 21 are integrally formed as the upper front wall part 28. Instead of the upper front wall part 28, the upper wall part 23 and the front wall part 27 may be formed not integrally but individually. Specifically, the housing 21 may include the upper wall part 23 defining the upper side of the housing 21 and formed alone, and the front wall part 27 including the first front wall part 35 and the second front wall part 36 defining the front side of the housing 21, connected to each other, and integrally formed. Thus, a maintenance worker can remove upward the upper wall part 23 blocking the upper side of the housing 21 only with work from the upper side in the seat back side space 17 having not much allowance in the front-back directional length. Accordingly, the maintenance worker can easily visually recognize the inside of the housing 21 and perform maintenance in the seat back side space 17 not having allowance in the front-back directional length.

In the above-described embodiment, the open-close part 37 including the hinge 38 and the open-close plate 39 is provided at the first front wall part 35. An open-close plate that slides and moves on the surface of the first front wall part 35 may be comprised in place of the rotational open-close part 37 including the hinge 38. Thus, in the seat back side space 17 having not much allowance in the front-back directional length, a maintenance worker can easily open the open-close part with not much inclining the seat 11 forward to rotate the open-close plate 39, and visually recognize the inside of the housing 21.

In the above-described embodiment, the housing 21 is fixed to the operating cab back part 5 by the housing fixation part 51 on the back surface side of the housing 21. Instead, the housing 21 may be fixed to the seat 11 by the housing fixation part 51 on the front surface side of the housing 21. In a method of fixation on the front surface side of the housing 21, the housing 21 may be fixed to, for example, the back surface of the seat 11 through the housing fixation part 51. Alternatively, the housing 21 may additionally comprise a fixation member stretched between and attached to the operating cab left side part 6 and the operating cab right side part 7 of the operating cab 2, and the housing 21 may be fixed to the fixation member through the housing fixation part 51 or directly.

As described above, the electronic device support mechanism of the present invention comprises the housing 21 that is disposed with a space adjacent to the lower structural object on the back side of the seat 11 and in which an electronic device is housed, at least one of the side wall parts of the housing 21 is provided with one of a vent and a fan, and the lower wall part of the housing 21 is provided with the other of the vent and the fan. Thus, since the electronic device support mechanism of the present invention has the space between the lower wall part and the lower structural object, air passing through the vent or fan provided at the lower wall part does not interfere with the lower structural object facing the lower wall part, and efficient air ventilation can be performed with small fluid resistance between the inside and outside of the housing 21. Accordingly, the electronic device support mechanism of the present invention can ensure heat dissipation capability of heat generated by the electronic device.

The electronic device support mechanism of the present invention comprises the housing 21 disposed on the back side of a seat comprised in the operating cab 2 of the construction machine, the first electronic device group 98 and the second electronic device group 99 are disposed with a gap in the horizontal direction in the housing 21, one of a vent 43 and a fan 42 is provided at a site that the gap faces a wall part of the housing 21, and the other is provided at each of the first wall part of the housing 21 to which the first electronic device group 98 is adjacent and the second wall part of the housing 21 to which the second electronic device group 99 is adjacent. Thus, in the electronic device support mechanism of the present invention, efficient air ventilation can be performed with small fluid resistance between the inside and outside of the housing 21. Accordingly, the electronic device support mechanism of the present invention can ensure heat dissipation capability of heat generated by the electronic device.

The first electronic device group and the second electronic device group are disposed with a gap in the horizontal direction in the housing of the electronic device support mechanism of the present invention, one of a vent and a fan is provided at a site that the gap faces at a wall part of the housing, and the other is provided at each of the first wall part of the housing to which the first electronic device group is adjacent and the second wall part of the housing to which the second electronic device group is adjacent.

In the electronic device support mechanism of the present invention, the first electronic device group and the second electronic device group are disposed with a gap in the horizontal direction, and one of a vent and a fan is provided at a site that the gap faces at a wall part of the housing. Thus, in the electronic device support mechanism of the present invention, efficient ventilation can be performed with small fluid resistance between the inside and outside of the housing.

The vent of the electronic device support mechanism of the present invention is provided at each of the left wall part and the right wall part, and the fan is provided in a central region of the wall part including the site that the gap faces.

In the electronic device support mechanism of the present invention, a fan and a vent are provided at different wall parts having their surfaces angled. Thus, it is possible to reduce probability that high-temperature air discharged from one of the fan and the vent is taken in again from the other and cooling efficiency decreases. Accordingly, the electronic device support mechanism of the present invention can efficiently cool electronic devices.

The housing of the electronic device support mechanism of the present invention includes an airflow adjustment member that defines a route through which air flows in the housing and is guided to the vent.

Since the housing of the electronic device support mechanism of the present invention includes the airflow adjustment member, air can efficiently flow in the housing. Accordingly, the electronic device support mechanism of the present invention can efficiently cool electronic devices.

The housing of the electronic device support mechanism of the present invention has the open-close part that is openable and closable at the front wall part.

The open-close part provided at the front wall part of the housing of the electronic device support mechanism of the present invention can open and close the housing while being attached. Thus, a maintenance worker can visually recognize the inside of the housing without removing the housing from the construction machine, thereby checking the state of any electronic device. Accordingly, with the electronic device support mechanism of the present invention, maintenance of the electronic device can be easily performed.

The housing of the electronic device support mechanism of the present invention has a step at the upper or lower surface of the housing.

The housing of the electronic device support mechanism of the present invention has a step at the upper or lower surface of the housing. Accordingly, the housing includes parts having different outer and inner sizes of the up-down dimension of the housing. Thus, a large electronic device can be housed at a part having a large inner size in the housing. Moreover, since a part having a small outer size is provided, it is possible to minimize space occupied by the housing including a part having a large inner size.

In the housing of the electronic device support mechanism of the present invention, a placement part on which an electronic device is mounted is comprised.

In the housing of the electronic device support mechanism of the present invention, the placement part is comprised. Thus, with the electronic device support mechanism of the present invention, a plurality of electronic devices having different sizes can be fixed at appropriate intervals in space in the housing, and an air flow path of efficient flow in the housing can be ensured.

The construction machine of the present invention is a construction machine comprising the above-described electronic device support mechanism, and the above-described electronic device is a remote operation electronic device.

In the construction machine of the present invention, at attachment of the remote operation electronic device, it is possible to attach the remote operation electronic device while ensuring heat dissipation capability with the above-described electronic device support mechanism.

### Reference Signs List

2 operating cab, 11 seat, 19 structural object (lower structural object), 21 housing, 22 lower wall part, 29 side wall part, 31 step, 42 fan, 43 vent, 45 airflow adjustment member, 37 open-close part, 88 placement part, 98 first electronic device group, 99 second electronic device group, 101 space, 102 gap

## Claims

1. An electronic device support mechanism comprising a housing that is disposed with a space adjacent to a lower structural object on a back side of a seat comprised in an operating cab of a construction machine and in which an electronic device is housed,
wherein one or more side wall parts of the housing and a lower wall part of the housing are each provided with one selected from among a vent and a fan.

2. An electronic device support mechanism comprising a housing disposed on a back side of a seat comprised in an operating cab of a construction machine, wherein
a first electronic device group and a second electronic device group each including an electronic device are disposed with a gap in a horizontal direction in the housing, and
one of a vent and a fan is provided at a site that the gap faces at a wall part of the housing, and the other is provided at each of a first wall part of the housing to which the first electronic device group is adjacent and a second wall part of the housing to which the second electronic device group is adjacent.

3. The electronic device support mechanism according to claim 1, wherein
a first electronic device group and a second electronic device group are disposed with a gap in a horizontal direction of the operating cab in the housing, and
one of a vent and a fan is provided at a site that the gap faces at a wall part of the housing, and the other is provided at each of a first wall part of the housing to which the first electronic device group is adjacent and a second wall part of the housing to which the second electronic device group is adjacent.

4. The electronic device support mechanism according to claim 2 or 3, wherein
the vent is provided at each of the first wall part and the second wall part, and
the fan is provided in a central region of the wall part including the site that the gap faces.

5. The electronic device support mechanism according to any one of claims 1 to 4, wherein the housing includes an airflow adjustment member that defines a route through which air flows in the housing and is guided to the vent.

6. The electronic device support mechanism according to any one of claims 1 to 5, wherein the housing has an open-close part that is openable and closable at a front wall part of the housing.

7. The electronic device support mechanism according to any one of claims 1 to 6, wherein the housing has a step at an upper surface or a lower surface of the housing.

8. The electronic device support mechanism according to any one of claims 1 to 7, wherein a placement part on which the electronic device is mounted is comprised in the housing.

9. A construction machine comprising the electronic device support mechanism according to any one of claims 1 to 8, wherein the electronic device is a remote operation electronic device.
